# EUROPEAN PATENT APPLICATION

(11) **EP 2 276 053 A1**
(43) Date of publication of application: **19.01.2011**
(21) Application number: 09165332.9
(22) Date of filing: 13.07.2009
(51) Int. Cl.: H01J 37/34

(54) **Target backing tube, cylindrical target assembly and sputtering system**

(71) Applicant: Applied Materials, Inc., Santa Clara, CA 95054 (US)
(72) Inventor: Schnappenberger, Frank, 55218 Ingelheim (DE); Weber, Roland, 63755 Alzenau (DE); Krempel-Hesse, Joerg, 63694 Limeshain (DE); Hellmich, Anke, 63796 Kahl (DE)
(74) Representative: Zimmermann & Partner

(57) **Abstract**

The present application concerns a target backing tube (122) for a rotatable cylindrical target assembly (120) comprising: a tube (122) for at least one target element (126) to be disposed there around, wherein the tube has an exterior surface adapted to be directed to the at least one target element; and a thermal reflection cover (128) covering a portion of at least 20% of the exterior surface of the tube. Further, the present application concerns a rotatable cylindrical target assembly comprising: said target backing tube and at least one target element disposed around the target backing tube, wherein the thermal reflection cover disposed between the target backing tube and the at least one target element.

## Description

The present disclosure relates to a target backing tube for a rotatable cylindrical target assembly. In particular the present disclosure relates to a target backing tube including a tube for at least one target element to be disposed there around. Further, the present disclosure relates to a rotatable cylindrical target assembly including a target backing tube and at least one target element disposed around the target backing tube. Additionally, the present disclosure relates to a sputtering system including a rotatable cylindrical target assembly.

### BACKGROUND

In many applications, it is necessary to deposit thin layers on a substrate. The term "substrate" as used herein shall embrace both inflexible substrates, e.g. a wafer or a glass plate, and flexible substrates such as webs and foils. Known techniques for depositing layers are in particular evaporating, sputtering and chemical vapor deposition.

Representative examples include (but are not limited to) applications involving: semiconductor and dielectric materials and devices, silicon-based wafers, flat panel displays (such as TFTs), masks and filters, energy conversion and storage (such as photovoltaic cells, fuel cells, and batteries), solid-state lighting (such as LEDs and OLEDs), magnetic and optical storage, micro-electro-mechanical systems (MEMS) and nano-electro-mechanical systems (NEMS), micro-optic and opto-elecro-mechanical systems (NEMS), micro-optic and optoelectronic devices, transparent substrates, architectural and automotive glasses, metallization systems for metal and polymer foils and packaging, and micro- and nano-molding.

In an evaporation process, the material to be deposited is heated so that it evaporates and condenses on the substrate. Sputtering is a vacuum coating process used to deposit thin films of various materials onto the surface of a substrate. For example, sputtering can be used to deposit a metal layer such as a thin layer of aluminum or ceramics. During the sputtering process, the coating material is transported from a target consisting of that material to the substrate to be coated by bombarding the surface of the target with ions of an inert gas that are accelerated by a high voltage. When the gas ions hit the outer surface of the target, their momentum is transferred to the atoms of the material so that some of them can gain sufficient energy to overcome their bonding energy in order to escape from the target surface and to deposit on the substrate. Thereon, they form a film of the desired material. The thickness of the deposited film is, inter alia, dependent on the duration of exposing the substrate to the sputtering process.

### SUMMARY

In light of the above, a target backing tube for a rotatable target according to independent claim 1, a rotatable cylindrical target assembly according to claim 19 and a sputtering system according to claim 23 are provided.

According to one embodiment, a target backing tube for a rotatable cylindrical target assembly is provided including: a tube for at least one target element to be disposed there around, wherein the tube has an exterior surface adapted to be directed to the at least one target element; and a thermal reflection cover covering a portion of at least 20% of the exterior surface of the tube.

In a typical embodiment, the portion is at least 60% of the exterior surface of the tube, particularly at least 90% of the exterior surface of the tube.

In an embodiment, the thermal reflection cover is a metal layer.

In a typical embodiment, which may be combined with other embodiments disclosed herein, the thermal reflection cover has an exterior surface adapted to be directed to the target element, wherein the exterior surface is coated with a metal.

Typically, the thermal reflection cover has an interior surface directed to the tube, wherein the interior surface is coated with a metal.

In another embodiment, the metal is copper, gold, silver, aluminium or the like.

For example, in an embodiment, the exterior surface of the thermal reflection cover is polished.

In an embodiment, the exterior surface of the thermal reflection cover adapted to be directed to the target element has a mean emissivity less than about 0.2, particularly a mean emissivity less than about 0.1.

For example, the thermal reflection cover has a reflectance of at least about 30% at a wavelength between 760 nm and 8000 nm.

In an embodiment, which may be combined with other embodiments disclosed herein, the thermal reflection cover has a reflectance of about at least 50%, particularly of about at least 70%.

Typically, the interior surface of the thermal reflection cover directed to the tube has a mean emissivity less than about 0.2.

In an embodiment, the interior surface of the thermal reflection cover directed to the tube has a mean emissivity less than about 0.1.

In a typical embodiment, at least one space is disposed between the thermal reflection cover and the target backing tube.

In an embodiment, which may be combined with other embodiments disclosed herein, the space between the thermal reflection cover and the tube has a size of about 0,1 mm to 2 mm in radial direction, in particular between 0,5mm and 1mm.

According to a further aspect, a rotatable cylindrical target assembly is provided including :a target backing tube, and at least one target element disposed around the target backing tube, wherein the thermal reflection cover disposed between the target backing tube and the at least one target element.

Typically, at least one space is disposed between the thermal reflection cover and the at least one target cylinder.

In an embodiment, which may be combined with other embodiments disclosed herein, the space between the thermal reflection cover and the target cylinder has a size of about 1 mm to about 300 mm in radial direction, in particular about 50 mm to about 200 mm

In a typical embodiment, the target cylinder is selected of the group consisting of an indium-tin oxide (ITO) target cylinder, an IGZO (InGaZnO) target cylinder, a ZAO (ZnO:Al) target cylinder, a GZO (ZnO:Ga) target cylinder, and an AGZO (ZnO:AlGa) target cylinder.

Further, a sputtering system including at least one rotatable cylindrical target assembly is provided.

Typically, the sputtering system may comprise two, three or more rotatable cylindrical target assemblies according an embodiment disclosed herein.

Further aspects, advantages and features of the present invention are apparent from the dependent claims, the description and the accompanying drawings.

### BRIEF DESCRIPTION OF THE DRAWINGS

A full and enabling disclosure including the best mode thereof, to one of ordinary skill in the art, is set forth more particularly in the remainder of the specification, including reference to the accompanying figures wherein:
Fig. 1 shows schematically a cross section of an embodiment of a sputtering system;
Fig. 2 shows a cross section of an embodiment of a rotatable cylindrical sputtering assembly;
Fig. 3 shows an enlarged view of a cross section of an embodiment of a rotatable cylindrical sputtering assembly.

### DETAILED DESCRIPTION

Reference will now be made in detail to the various embodiments, one or more examples of which are illustrated in each figure. Each example is provided by way of explanation and is not meant as a limitation. For example, features illustrated or described as part of one embodiment can be used on or in conjunction with other embodiments to yield yet further embodiments. It is intended that the present disclosure includes such modifications and variations.

The process of coating a substrate as a material at the scraping refers typically to thin film applications. The term "coating" and the term "depositing" are used synonymously herein.

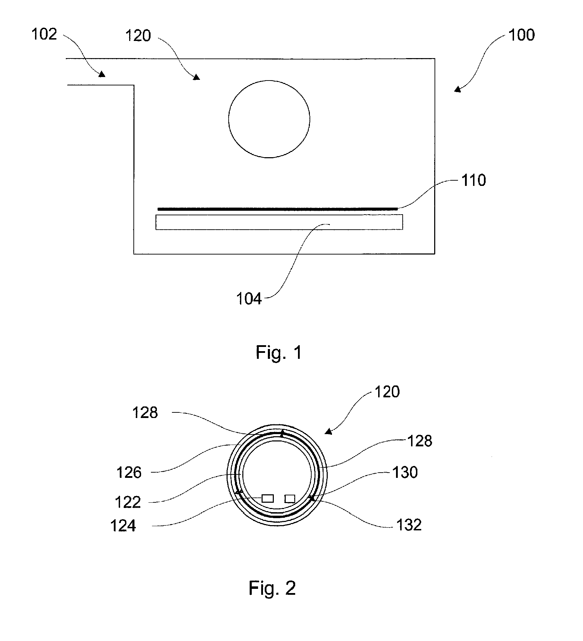

Fig. 1 shows a vacuum chamber 100 including a gas inlet 102 for providing processing gas, for example argon, to the vacuum chamber. The vacuum chamber further includes a substrate support 104 and a substrate 110 arranged on the substrate support 104. Further, the vacuum chamber 100 includes a rotating cylindrical target assembly 120, typically in a cantilevered arrangement above the substrate 110. Typically, the rotating axis is arranged substantially horizontal. The rotating axis corresponds, in an embodiment, to the cylinder axis of the cylindrical target assembly.

In operation, the cylindrical target assembly 120 rotates about its longitudinal axis and a plasma is generated between the cylindrical target assembly 120 and the substrate 110. The plasma is formed typically by Argon ions that are accelerated in direction of target elements of the cylindrical target assembly, such that particles of a target element of the cylindrical target assembly are sputtered and subsequently deposited on the substrate 110. In other embodiments, other suitable gases may be used to create the plasma. In a further embodiment, the vacuum chamber may include one or more openings and/or valves for introducing or retracting the substrate in or out of the vacuum chamber 100. Even though Fig. 1 shows one target assembly, according to different embodiments, which may be combined with other embodiments disclosed herein two or more rotating cylindrical target assemblies 120 are disposed in the vacuum chamber. In a typical embodiment, the cylindrical axes of the two or more rotating cylindrical target assemblies are substantially parallel.

Fig. 2 shows an embodiment of a cylindrical target assembly in cross sectional view. The cylindrical target assembly 120 includes a backing tube 122, in which magnetrons 124 are disposed for generating the plasma within the vacuum chamber 100 between the target assembly 120 and the substrate 110. Typically, a cooling fluid is circulating within the backing tube for cooling the magnetrons 124. Further, target elements 126 are provided around the backing tube 122. The target elements provide the material to be sputtered. For example, the target elements may include indium tin oxide (ITO) or silicon to be sputtered. Thus, the longer the coating process is taking place, the more material is used from sputtered by the target elements. In operation, the cylindrical target assembly rotates about its longitudinal or cylindrical axis such that the material of the target elements is worn or sputtered regularly about its circumference. In a typical embodiment, at least two, for example three, four or more, target elements are disposed side by side around the backing tube. In a typical embodiment, the number and the kind of target elements may depend on the material to be sputtered.

In a typical embodiment, which may be combined with other embodiments disclosed herein, the target elements 126 are not bonded to the backing tube 122. For example, the target elements may be centered and supported by springs or centering elements, wherein the springs or centering elements may be regularly disposed around the circumference of the backing tube.

Thereby, an important factor to be considered for the disclosed embodiments is the fact that the target elements and the backing tube are located in a vacuum environment, for example in the vacuum chamber 100. According to typical embodiments, which can be combined with other embodiments described herein, the pressure in the plasma area can be 10⁻⁴ to 10⁻² mbar, typically about 10⁻³ mbar.

Thus, in a typical embodiment, there are substantially no particles or atoms between the outer surface of the backing tube 122 facing the target elements and the inner surface of the target elements 126 facing the backing tube 122. Typically, under vacuum a heat transfer contact cannot be established well without a contact pressure. The contact pressure depends on the contact with respect on a scale of the surface roughness of the contacting surfaces. In light of the above a contact heat transfer might not be effectively established, but rather a radiation heat exchange is a dominant process. According to Stefan-Boltzmann law the total energy radiated per unit surface area of a black body is proportional to the fourth power of the black body's temperature T (absolute temperature). In a case of a gray body, that is a body that does not absorb or emit the full amount of radiative flux, the gray body radiates only a portion of the radiative flux that is characterized by its emissivity ε.

Typically, in an embodiment which may be combined with other embodiments disclosed herein, the amount of nodules deposited on the substrate may be reduced in a temperature range of the target elements of about 350 °C to about 550 °C and above, for example in case of an indium tin oxide (ITO) target elements. For other target elements other temperature ranges may apply.

In a sputtering system a lot of energy is needed, on the one hand for cooling the magnetrons 124 and on the other hand for heating the vacuum chamber for creating a plasma and the deposition of particles on the substrate. Thus, in a typical embodiment which may be combined with other embodiments disclosed herein, the energy consumption may be reduced by and a "green" system may be provided if energy, e.g., for heating, is not at the same time inserted in and removed from the system. Accordingly, according to some embodiments, which can be combined with other embodiments described herein, a radiation reflection layer 128 between an outer surface of the backing tube facing the at least one target elements and the inner surface of the at least one target element 126 facing the backing tube can be provided. In light of the radiation dominant heat transfer, an intermediate layer, e.g. a radiation reflection layer, might according to embodiments described herein rather act as a radiation reflector than as a heat transfer layer. The radiation reflection layer reflects the heat of the at least one target element such that there is a reduced heat exchange between the target and the cooled backing tube.. Thus, the cooling power in the system may be reduced with respect to embodiments, where no radiation reflection layer 128 is used.

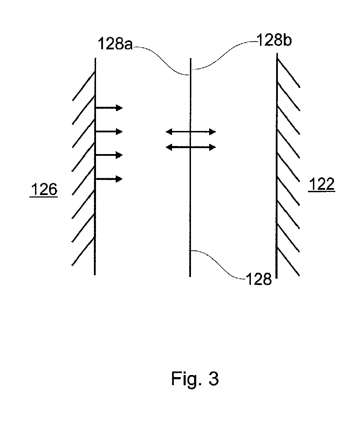

Fig. 3 shows an enlarged portion of a section of a cylindrical sputtering system 120. The cylindrical target assembly includes a backing tube 122, a radiation reflection layer or a thermal reflection cover 128 and a target element 126. As it can be seen from Fig. 3, a space is disposed between the target element 126 and the reflection layer 128, and between the reflection layer 128 and the backing tube 122. The space is shown to be enlarged in Fig. 3, because under vacuum even small gaps might act as a space without significant contact for heat transfer. A space may be only eliminated in case the target elements would be pressed on the backing tube 122. The target elements may expand and retract due to temperature changes. For example, the cylindrical target assembly 120 may be assembled at ambient temperature outside the vacuum chamber and subsequently disposed into the vacuum chamber before the operation starts. Then the plasma heats the vacuum chamber and thus the target elements 126 to an optimal operation point.

In operation, as already described here above, the backing tube is cooled, because the magnetrons in the backing tube may only operate below a predetermined temperature. For example, a typical temperature of a backing tube is about 50 °C to 100 °C. On the other hand, the target elements 126 may have a high temperature, for example 100 °C or more, in another embodiment between 400 °C and about 700 °C.

For example, in an embodiment, which may be combined with other embodiments herein, the radiation reflection layer may be a metal foil. Typically, the metal foil is loosely fitted on the backing tube, i.e. the metal foil is not pressed by the target elements on the backing tube. In a further embodiment, the metal foil may be fixed the ends of the backing tube in axial direction of the backing tube.

In other embodiments, the radiation reflection layer may be a casing. For example, the casing may be fixed to the backing tube by one or more first centering elements, biasing members, springs, or the like 130. Typically, the centering elements, biasing members, springs, or the like may be disposed in regular intervals around the circumference of the backing tube. In a further embodiment, which may be combined with other embodiments disclosed herein, the target elements may be fixed on the radiation reflection layer by one or more second centering elements, biasing members, springs, or the like 132. In a typical embodiment, the first and the second centering elements are disposed substantially at the same circumferential position.

In a further embodiment, which may be combined with other embodiments disclosed herein, the radiation reflection layer may present openings for centering elements, biasing members, springs or the like for centering and holding the target elements with respect to the backing tube. Thus, the target elements are directly sustained by the backing tube. For example the radiation reflection layer or the thermal reflection cover may include at least 3, in particular at least 6, openings per target element.

In a typical embodiment, the metal surface of the radiation reflection layer may be polished to provide a high reflectance and/or a low emissivity. In a typical embodiment, the radiation reflection layer 128 has a thermal reflection factor (reflectance) of 0.3 to 1, in particular from 0.5 to 1, for thermal radiation from the target elements. In a further embodiment, the radiation reflection layer may have a reflectance of about at least 0.7. In an embodiment, which may be combined with other embodiments disclosed herein, the reflectance is measured in a wavelength range of about 760 nm to about 8000 nm.

In a typical embodiment, the reflection layer may have a gold, silver, aluminium, or copper surfaces towards the backing tube 122 and/or towards the target elements 126.

In Fig. 3, the heat radiation of the target elements 126 is partly reflected at the radiation reflection layer 128, in particular at the outer surface 128a of the radiation reflection layer 128. For example, a space in radial direction is disposed between an outer surface of the radiation reflection layer facing the target elements and an inner surface of the target elements facing the backing tube. For example the space may have a size of 1mm to about 300 mm. Thereby, an important factor to be considered for the disclosed embodiments is the fact that the target elements, the backing tube, and the radiation reflection layer are located in a vacuum environment, for example in the vacuum chamber 100. Thus, in a typical embodiment, there is substantially no molecules, e.g. for transporting the heat, between the backing tube and the radiation reflection layer, and the radiation reflection layer and the backing tube. For example, the thermal radiation of the exterior surface of the backing tube, the surfaces of the radiation reflection layer and/or the interior surface of the target elements may be important for the thermal properties of the cylindrical target assembly.

For example, a thermal reflection at the exterior surface of the radiation reflection layer may reflect the heat of the target elements. A further space in radial direction is disposed between an outer surface of the backing tube facing the target elements and an inner surface of the radiation reflection layer facing the backing tube. For example, the space may have a size of 0,1 to about 2 mm. Thus, only a part of the radiation of the cylindrical target element 126 reaches the backing tube. Hence, the cooling power for the magnetrons in the backing tube may be reduced compared within an embodiment without a radiation reflection layer.

In a further embodiment, which may be combined with other embodiments disclosed herein, the radiation reflection layer may cover at least 50%, for example at least 70%, or in some embodiments more than 90%, of an exterior surface of the backing tube, wherein the exterior surface is directed towards the target elements. In another embodiment, the radiation reflection layer covers substantially the complete exterior surface of the backing tube.

In typical embodiments, the concept of a target heating may be seen as a green factory such that not hundreds and thousands of megawatt are used for removing power that has been inserted in the fabrication processes. Further, the temperature uniformity of the target elements is improved. For example, further to having a low absorption coating a sheet of metal or the like (solid layer) may be used as a mirror.

According to yet further embodiments, which can be combined with other embodiments described herein, also two, four, six or more reflection layers or thermal reflection covers can be provided between the backing tube and the target elements. Thus, the effect of reduced heat transfer based on radiation, which is explained with respect to Fig. 3 can be even further improved by additional reflection layers or shields. Thereby, the additional reflections shields can be provided similarly as described above. As further optional or alternative modifications also the centering elements may be provided as described above for the additional reflection covers.

This written description uses examples to disclose the invention, including the best mode, and also to enable any person skilled in the art to practice the described subject-matter, including making and using any devices or systems and performing any incorporated methods. While various specific embodiments have been disclosed in the foregoing, those skilled in the art will recognize that the spirit and scope of the claims allows for equally effective modifications. Especially, mutually non-exclusive features of the embodiments described above may be combined with each other. The patentable scope is defined by the claims, and may include such modifications and other examples that occur to those skilled in the art. Such other examples are intended to be within the scope of the claims if they have structural elements that do not differ from the literal language of the claims, or if they include equivalent structural elements with insubstantial differences from the literal language of the claims.

## Claims

1. A target backing tube (122) for a rotatable cylindrical target assembly (120) comprising:
a tube (122) for at least one target element (126) to be disposed there around,
wherein the tube has an exterior surface adapted to be directed to the at least one target element; and
a thermal reflection cover (128) covering a portion of at least 20% of the exterior surface of the tube.

2. The target backing tube according to claim 1, wherein the portion is at least 60% of the exterior surface of the tube, particularly at least 90% of the exterior surface of the tube.

3. The target backing tube according to one of the claims 1 or 2, wherein the thermal reflection cover is a metal layer.

4. The target backing tube according to one of the claims 1 to 3, wherein the exterior surface of the thermal reflection cover is polished.

5. The target backing tube according to one of the claims 1 to 4, wherein the exterior surface of the thermal reflection cover adapted to be directed to the target element has a mean emissivity less than about 0.2, particularly a mean emissivity less than about 0.1.

6. The target backing tube according to one of the claims 1 to 5, wherein the thermal reflection cover has a reflectance of at least about 30%, in particular at least 50%, particularly of about at least 70%, at a wavelength between 760 nm and 8000 nm.

7. The target backing tube according to one of the claims 1 to 10, wherein the interior surface of the thermal reflection cover directed to the tube has a mean emissivity less than about 0.2, in particular less than about 0.1.

8. The target backing tube according to one of the claims 1 to 12, wherein at least one space is disposed between the thermal reflection cover and the target backing tube.

9. The target backing tube according to claim 13, wherein the space between the thermal reflection cover and the tube has a size of about 0,1 mm to 2 mm in radial direction, in particular between 0,5mm and 1mm.

10. A rotatable cylindrical target assembly comprising:
a target backing tube according to one of the claims 1 to 14,
and at least one target element (126) disposed around the target backing tube,
wherein the thermal reflection cover disposed between the target backing tube and the at least one target element.

11. The rotatable cylindrical target assembly according to claim 15, wherein at least one space is disposed between the thermal reflection cover and the at least one target cylinder.

12. The rotatable cylindrical target assembly according to claim 16, wherein the space between the thermal reflection cover and the target cylinder has a size of about 1 mm to about 300 mm in radial direction, in particular about 50 mm to about 200 mm

13. The rotatable cylindrical target assembly according to one of the claims 15 to 17, wherein the target cylinder is selected of the group consisting of an indium-tin oxide (ITO) target cylinder, an IGZO (InGaZnO) target cylinder, a ZAO (ZnO:Al) target cylinder, a GZO (ZnO:Ga) target cylinder, and an AGZO (ZnO:AlGa) target cylinder.

14. A sputtering system (100) comprising:
at least one rotatable cylindrical target assembly according to one of the claims 15 to 18.

15. The sputtering system according to claim 19 comprising two, three or more rotatable cylindrical target assemblies according to one of the claims 15 to 18.
